# EUROPEAN PATENT SPECIFICATION

(11) **EP 1 418 679 B1**
(45) Date of publication and mention of the grant of the patent: **26.07.2006**
(21) Application number: 04002253.5
(22) Date of filing: 01.12.1998
(51) Int. Cl.: H04B 1/40, H04B 1/52, H04B 1/48, H05K 1/02, H01P 1/15

(54) **Multiband high-frequency switching module**
Multibandhochfrequenzschaltmodul
Module de commutation multibande pour radiofréquences

(30) Priority: 03.12.1997 JP 33335897; 05.12.1997 JP 33519897; 28.04.1998 JP 11803998; 27.07.1998 JP 21120898
(43) Date of publication of application: 12.05.2004
(62) Divisional of application: 98122784.6
(73) Proprietor: HITACHI METALS, LTD., Minato-ku, Tokyo (JP)
(72) Inventor: Kemmochi, Shigeru, Tottori-shi Tottori-ken (JP); Watanabe, Mitsuhiro, Tottori-shi Tottori-ken (JP); Tai, Hiroyuki, Tottori-shi Tottori-ken (JP); Taketa, Tsuyoshi, Iwami-gun Tottori-ken (JP); Tanaka, Toshihiko, Tottori-shi Tottori-ken (JP)
(74) Representative: Strehl Schübel-Hopf & Partner

(56) References cited:
- EP-A- 0 567 766
- EP-A- 0 578 160
- EP-A- 0 704 925
- US-A- 5 473 293

## Description

### BACKGROUND OF THE INVENTION

The present invention relates to a high-frequency composite circuit part, more specifically, to a multiband high-frequency switching module used in a communication system utilizing a plurality of transmit-receive systems having different passbands.

A digital cellular radiotelephone uses a high-frequency switch to alternately and electrically connect an antenna (ANT) to a transmitting circuit (TX) or a receiving circuit (RX).

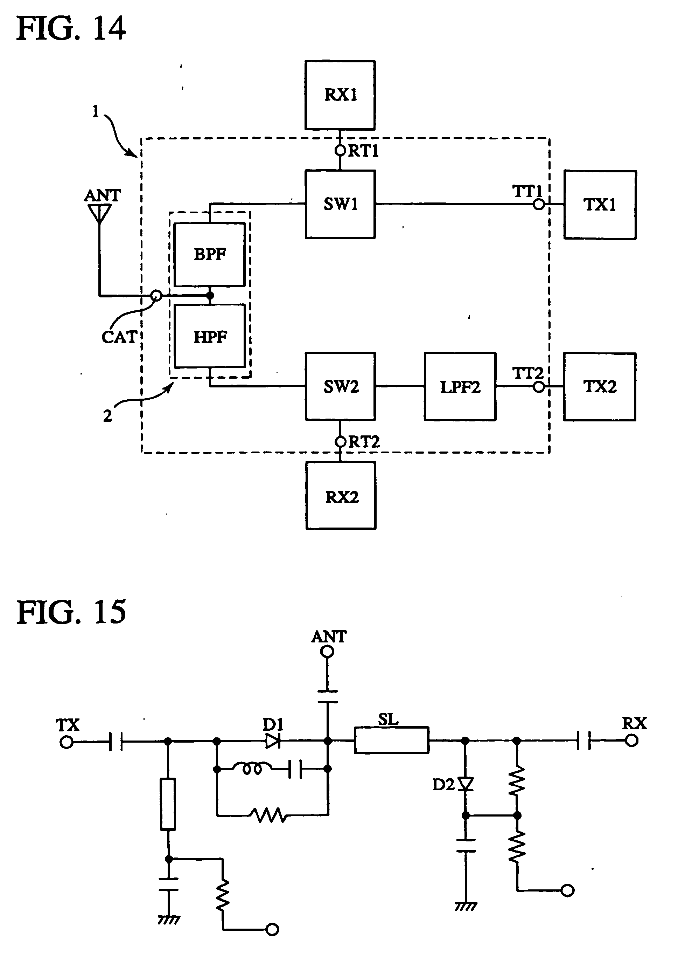

Fig. 15 is a schematic circuit diagram showing a conventional single-band high-frequency switch circuit disclosed in US-A-5,473,293. In Fig. 15, the high-frequency switch alternately connects an antenna ANT to a transmitting circuit TX or a receiving circuit RX, and comprises a first switching element D1, the anode thereof being connected to the transmitting circuit TX and the cathode thereof being connected to the antenna ANT, a strip line SL connected between the antenna ANT and the receiving circuit RX, and a second switching element D2, the anode thereof being connected between the strip line SL and the receiving circuit RX and the cathode thereof being grounded. The high-frequency switch is made into a dielectric laminate body having a plurality of layers, in which the strip line SL is disposed on an inner layer and the switching elements D1, D2 are mounted on the top surface of the dielectric laminate body.

With the recent striking spread of the cellular radiotelephone, there has been increased demand for improving the performance thereof, expanding the service area, etc. As a radiotelephone of new type, a dual-band radiotelephone has been proposed. In contrast to the conventional radiotelephone which utilizes a single transmit-receive system, the dual-band radiotelephone uses two transmit-receive systems having different passbands. A user may communicate by suitably selecting a desired transmit-receive system.

If the respective transmit-receive systems are constituted by different circuits, the resultant dual-band radiotelephone would become large in its size and expensive. Therefore, the parts for the dual-band radiotelephone, as many as possible, should be shared between the transmit-receive systems in view of reducing the size and the production cost.

EP-A-0 567 766 discloses a circuit including frequency filters for an switching automobile antenna so as to associate different frequency ranges to different receivers.

### OBJECT AND SUMMARY OF THE INVENTION

Accordingly, an object of the present invention is to provide a multiband high-frequency switching module for alternately and electrically connecting a common antenna to a transmitting circuit or a receiving circuit of any one of two or more transmit-receive systems having different passbands.

Another object of the present invention is to provide a multiband high-frequency switching module made into a small laminated structure.

Thus, an aspect of the present invention, there is provided a multiband high-frequency switching module in the form of a laminate body for use in a communication system utilizing a plurality of transmit-receive systems having different passbands, a circuit of the multiband high-frequency switching module comprising: (a) a band-separating circuit 2 having one end connected to a common antenna ANT, the band-separating circuit 2 being constituted by filter circuits, each comprising a LC circuit; and (b) a switching circuit SW1, SW2 for switching a transmitting circuit TX1, TX2 and a receiving circuit RX1, RX2 in the transmit-receive systems, having one end connected to the band-separating circuit 2 and the other end connected in parallel to a receive terminal RT1, RT2 for connecting the receiving circuit RX1, RX2 and a transmit terminal TT1, TT2 for connecting the transmitting circuit TX1, TX2 so as to connect the common antenna ANT alternately to the receiving circuit RX1, RX2 and the transmitting circuit TR1, TX2, each switching circuit SW1, SW2 comprising at least one transmission line LG1, LG2, LP1, LP2, and the laminate body comprising a plurality of dielectric layers 11-22, pattern electrodes 41-71 printed on the dielectric layers, terminal electrodes 81-96 formed on surfaces of the laminate body, and chip elements CP1-LP4 mounted on a top surface of the laminate body, wherein the pattern electrodes 45, 44 of at least the transmission lines LG2, LP2 connected to the receiving circuit RX1, RX2 for the plurality of switching circuits SW1, SW2 are formed on the same surface of at least one of the layers 13, 14 separately in the horizontal direction of the laminate body.

### BRIEF DESCRIPTION OF THE DRAWINGS

Fig. 1 is a block schematic diagram showing a preferred embodiment of the multiband high-frequency switching module according to the present invention;
Fig. 2 is a schematic circuit diagram showing an equivalent circuit of the multiband high-frequency switching module of Fig. 1;
Fig. 3 is a plan view of a laminate body of the multiband high-frequency switching module according to the present invention;
Fig. 4 is a perspective view of a laminate body of the multiband high-frequency switching module according to the present invention;
Fig. 5 is a plan view showing each layer constructing the laminate body of Figs. 3 and 4;
Fig. 6 is a block schematic diagram showing a first preferred circuit of the multiband high-frequency switching module according to the present invention;
Fig. 7 is a block schematic diagram showing a second preferred circuit of the multiband high-frequency switching module according to the present invention;
Fig. 8 is a block schematic diagram showing a third preferred circuit of the multiband high-frequency switching module according to the present invention;
Fig. 9 is a block schematic diagram showing a fourth preferred circuit of the multiband high-frequency switching module according to the present invention;
Fig. 10 is a block schematic diagram showing a fifth preferred circuit of the multiband high-frequency switching module according to the present invention;
Fig. 11 is a block schematic diagram showing a sixth preferred circuit of the multiband high-frequency switching module according to the present invention;
Fig. 12 is a block schematic diagram showing a seventh preferred circuit of the multiband high-frequency switching module according to the present invention;
Fig. 13 is a block schematic diagram showing a eighth preferred circuit of the multiband high-frequency switching module according to the present invention;
Fig. 14 is a block schematic diagram showing a ninth preferred circuit of the multiband high-frequency switching module according to the present invention; and
Fig. 15 is a schematic circuit diagram showing a conventional single-band high-frequency switch circuit.

### DESCRIPTION OF THE PREFERRED EMBODIMENTS

The multiband high-frequency switching module of the present invention comprises a band-separating circuit, switching circuits each alternately connecting a common antenna to a receiving circuit or a transmitting circuit of any one of a plurality of transmit-receive systems having different passbands, and terminals for connecting the common antenna ANT, the receiving circuit, or the transmitting circuit.

The present invention will be described while taking a high-frequency switching module for a dual-band system as an example. However, it should be noted that the present invention is equally applicable to a communication system including three or more transmit-receive systems having different passbands, regardless of the following description of preferred embodiments.

In a preferred embodiment of the present invention, the multiband high-frequency switching module may comprise a band-separating circuit 2, a first switching circuit SW1 for a first transmit-receive system and a second switching circuit SW2 for a second transmit-receive system. Such a multiband high-frequency switching module is suitable for use in a dual-band cellular radiotelephone.

The band-separating circuit 2 separates a communication signal into two bands for the first and second transmit-receive systems. The band-separating circuit 2 is constituted by two filter circuits NF1, NF2, each comprising an inductor component LF1, LF2 and a capacitor component CF1, CF2 and corresponding to each of the first and second transmit-receive systems. The circuits for the band-separating circuit 2 may be filter circuits NF1, NF2, low path filter circuits LPF, high path filter circuits HPF, band path filter circuits, or any combination of these circuits.

For example, the band-separating circuit 2 may be constituted by first and second filter circuits NF1, NF2, each comprising parallel-connected inductor and capacitor. One end of each filter circuit is respectively connected to the corresponding switching circuit, and the other end thereof is connected to a common antenna terminal CAT for connecting the common antenna ANT. Between one of the filter circuits and its corresponding switching circuit, a capacitor being grounded may be connected in a shunt configuration. Between the other filter circuit and its corresponding switching circuit, a capacitor may be connected and an inductor being grounded may be further connected in a shunt configuration between the filter circuit and the capacitor.

Each of the first and second transmit-receive systems includes one switching circuit SW1, SW2, one end thereof being connected to the band-separating circuit 2 which is connected to the common antenna ANT for connecting the common antenna terminal CAT, another end thereof being connected to a receive terminal RT1, RT2 for connecting the receiving circuit RX1, RX2, and still another end thereof being connected to a transmit terminal TT1, TT2 for connecting the transmitting circuit TX1, TX2. Thus, the first switching circuit SW1 alternately connects the common antenna ANT to a first transmitting circuit TX1 or a first receiving circuit RX1, and the second switching circuit SW2 alternately connects the common antenna ANT to a second transmitting circuit TX2 or a second receiving circuit RX2.

The switching circuit may be a switching element switching circuit which is connected to a control circuit through a control terminal to apply a voltage of a predetermined level to the switching elements, thereby controlling the switching operation. For example, the multiband high-frequency switching module may have first and second control terminals, for controlling the transmitting circuits of the first and second transmit-receive systems, and third and fourth control terminals for controlling the receiving circuits of the first and second transmit-receive systems. The receiving circuits of the first and second transmit-receive systems may be controlled by the same control terminal.

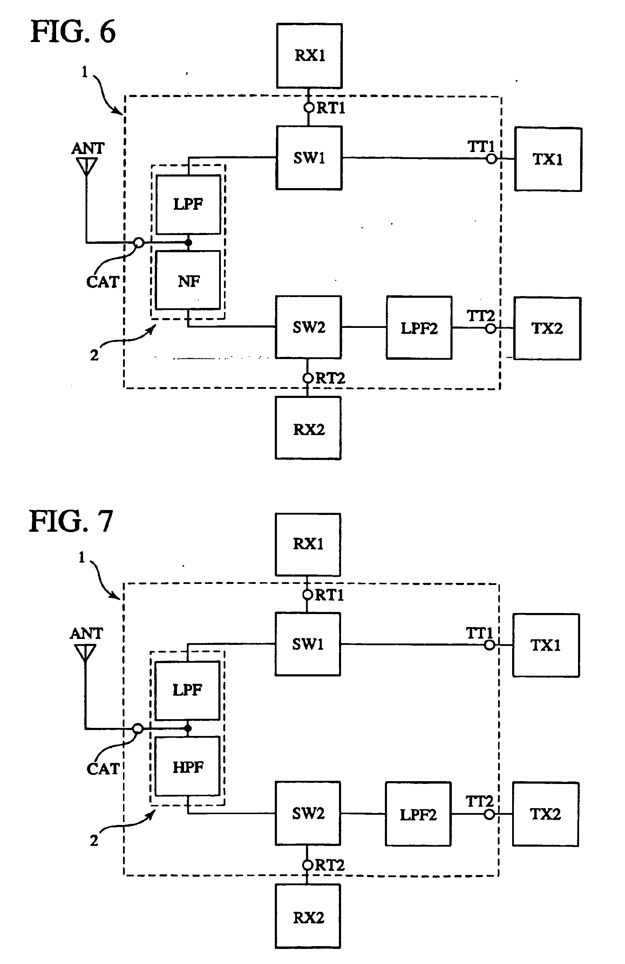

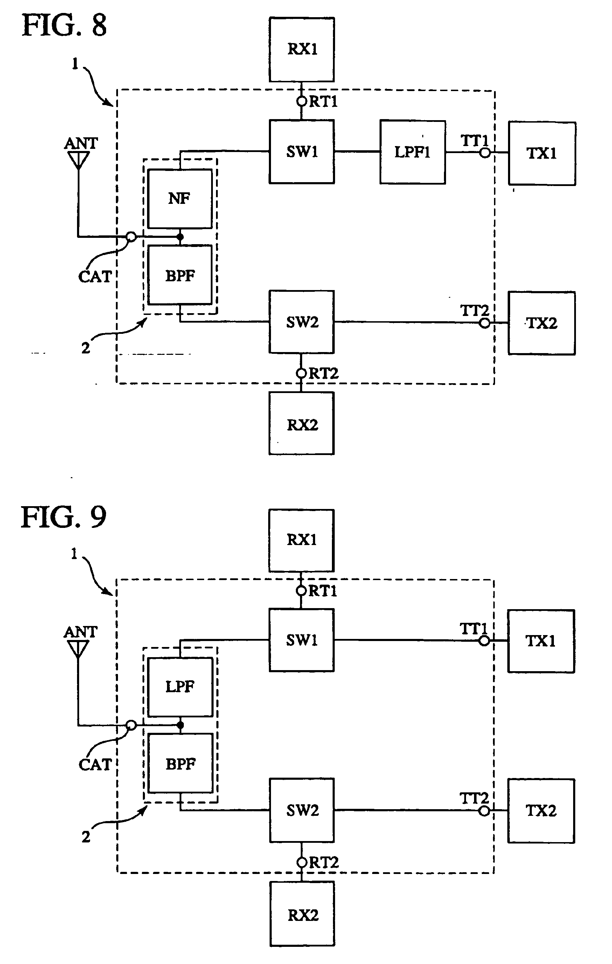

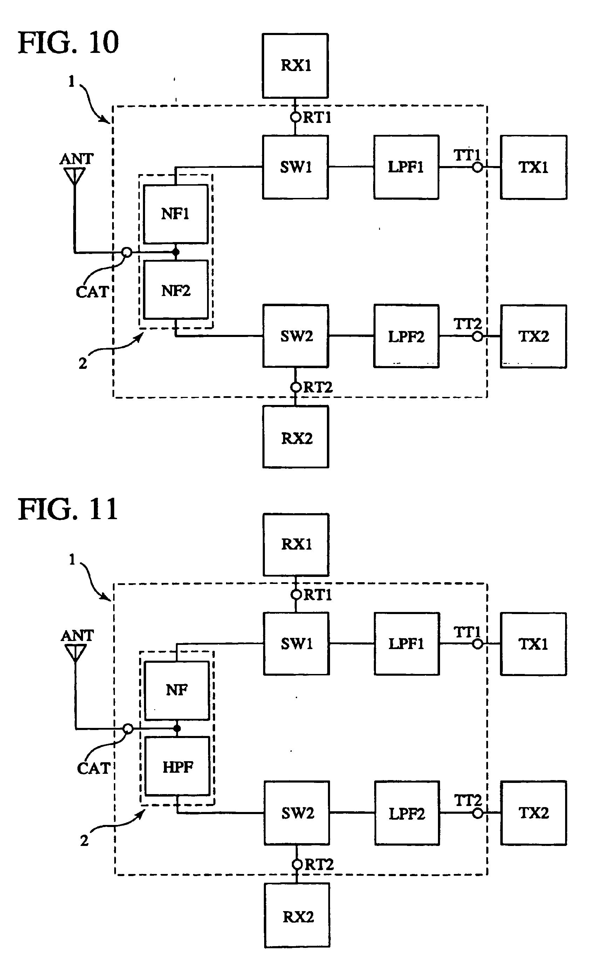

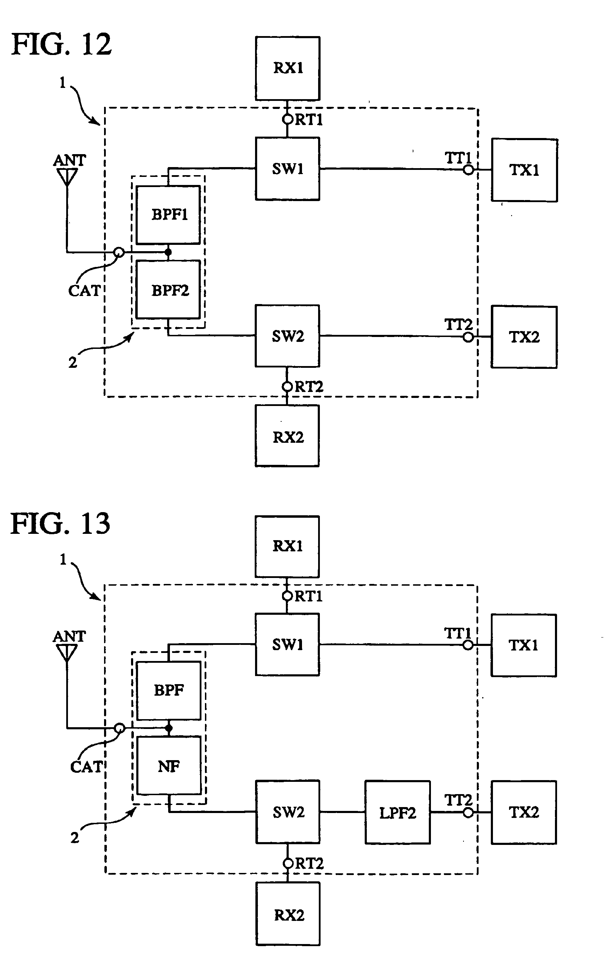

A low path filter circuit LPF comprising an inductor component and a capacitor component may be incorporated into the switching circuit SW1, SW2 to provide the transmit system (a path from the common antenna terminal CAT to the transmit terminal TT1, TT2 through the band-separating circuit 2 and the switching circuit SW1, SW2) of each transmit-receive system with a low path filtering function. Thus, the multiband high-frequency switching module of the present invention may include the following various circuit construction.
(A) As shown in Fig. 6, in a first preferred circuit, the band-separating circuit 2 is constituted by a low path filter circuit LPF for the first transmit-receive system and a filter circuit NF for the second transmit-receive system, and a low path filter circuit LPF2 is incorporated into the second switching circuit SW2.
(B) As shown in Fig. 7, in a second preferred circuit, the band-separating circuit 2 is constituted by a low path filter circuit LPF for the first transmit-receive system and a high pass filter circuit HPF for the second transmit-receive system, and a low path filter circuit LPF2 is incorporated into the second switching circuit SW2.
(C) As shown in Fig. 8, in a third preferred circuit, the band-separating circuit 2 is constituted by a filter circuit NF for the first transmit-receive system and a band pass filter circuit BPF for the second transmit-receive system, and a low path filter circuit LPF1 is incorporated into the first switching circuit SW1.
(D) As shown in Fig. 9, in a fourth preferred circuit, the band-separating circuit 2 is constituted by a low pass filter circuit LPF for the first transmit-receive system and a band pass filter circuit BPF for the second transmit-receive system. No low path filter circuit is incorporated into the switching circuits, because the band pass filter circuit BPF has a function of low pass filter.
(E) As shown in Fig. 10, in a fifth preferred circuit, the band-separating circuit 2 is constituted by a first filter circuit NF1 for the first transmit-receive system and a second filter circuit NF2 for the second transmit-receive system. A first low path filter circuit LPF1 and a second low path filter circuit LPF2 are respectively incorporated into the first switching circuit SW1 and the second switching circuit SW2.
(F) As shown in Fig. 11, in a sixth preferred circuit, the band-separating circuit 2 is constituted by a filter circuit NF for the first transmit-receive system and a high pass filter circuit HPF for the second transmit-receive system. A first low path filter circuit LPF1 and a second low path filter circuit LPF2 are respectively incorporated into the first switching circuit SW1 and the second switching circuit SW2.
(G) As shown in Fig. 12, in a seventh preferred circuit, the band-separating circuit 2 is constituted by a first band pass filter circuit BPF1 for the first transmit-receive system and a second band pass filter circuit BPF2 for the second transmit-receive system. No low path filter circuit is incorporated into the switching circuits, because the band pass filter circuits BPF1 and BPF2 have a function of low pass filter.
(H) As shown in Fig. 13, in an eighth preferred circuit, the band-separating circuit 2 is constituted by a band pass filter circuit BPF for the first transmit-receive system and a filter circuit NF for the second transmit-receive system, and a low path filter circuit LPF2 is incorporated into the second switching circuit SW2.
(I) As shown in Fig. 14, in a ninth preferred circuit, the band-separating circuit 2 is constituted by a band pass filter circuit BPF for the first transmit-receive system and a high pass filter circuit HPF for the second transmit-receive system, and a low path filter circuit LPF2 is incorporated into the second switching circuit SW2.

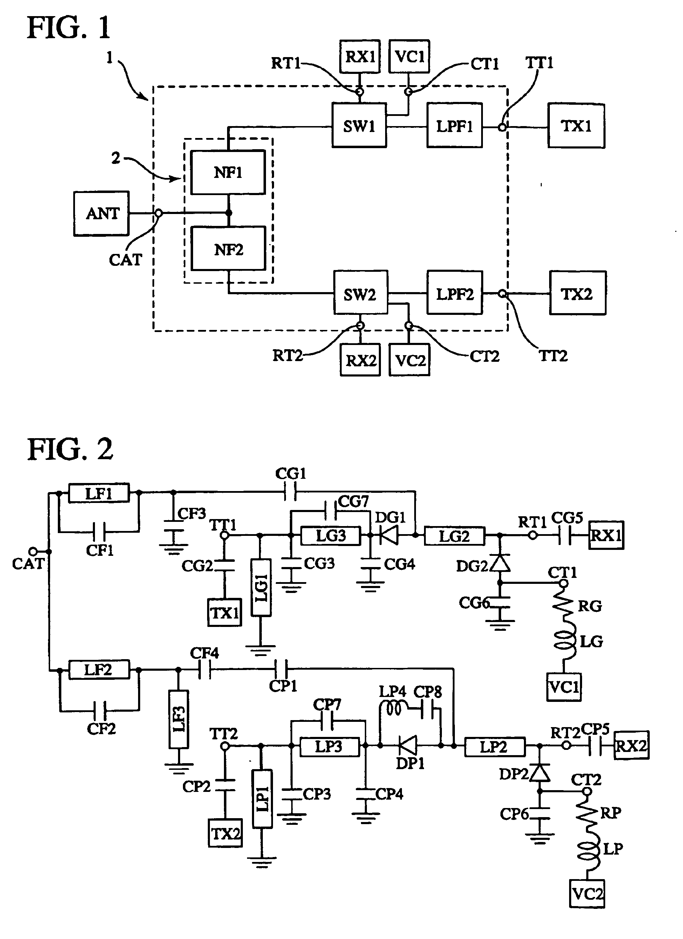

Fig. 1 is a block schematic diagram showing a preferred embodiment of the multiband high-frequency switching module according to the present invention. The multiband high-frequency switching module 1 surrounded by broken line is used in a communication system utilizing two transmit-receive systems having different passbands, and suitable for alternately connecting a common antenna ANT to a transmitting circuit (TX1, TX2) and a receiving circuit (RX1, RX2) of each transmit-receive system in a dual-band radiotelephone. For example, a first transmit-receive system may be (Global System for Mobile Communication (GSM) and a second transmit-receive system may be Digital Cellular System (DCS) 1800 system.

The multiband high-frequency switching module 1 of Fig. 1 comprises a first switching circuit SW for switching a transmitting circuit TX1 and a receiving circuit RX1 of the first transmit-receive system (GSM), a first low pass filter circuit LPF1 incorporated into the first switching circuit SW1, a first transmit terminal TT1 for connecting the transmitting circuit TX1, a second switching circuit SW2 for switching a transmitting circuit TX2 and a receiving circuit RX2 of the second transmit-receive system (DCS), a second low path filter circuit LPF2 incorporated into the second switching circuit SW2, a second transmit terminal TT2 for connecting the transmitting circuit TX2, and a band-separating circuit 2 for separating the bands of communication signals to the respective transmit-receive systems. The switching circuits SW1, SW2 may have control terminals CT1, CT2 for respectively connecting control circuits VC1, VC2. The band-separating circuit comprises first and second filter circuits NF1, NF2, one end of each filter circuit being connected to a common antenna terminal CAT for connecting a common antenna ANT, and the other end thereof being connected to respective switching circuit. The receiving circuits RX1, RX2 are respectively connected to the switching circuits SW1, SW2 through receive terminals RT1, RT2.

Fig. 2 is a schematic circuit diagram showing an equivalent circuit of the multiband high-frequency switching module of Fig. 1. The band-separating circuit connected to the common antenna terminal CAT includes first and second circuits, the first circuit comprising parallel-connected inductor LF1 and capacitor CF1 and the second circuit comprising parallel-connected inductor LF2 and capacitor CF2. One of the ends of the first circuit is connected to the common antenna terminal CAT and the opposite end is grounded through a capacitor CF3 for enhancing the low pass filtering operation of the band-separating circuit. One of the ends of the second circuit is connected to the common antenna terminal CAT and the opposite end is connected to a capacitor CF4 and an inductor LF3 being grounded. The inductor LF3 and the capacitor CF4 enhance the high pass filtering operation of the band-separating circuit.

The first switching circuit SW1 comprises switching elements DG1, DG2 and transmission lines LG1, LG2. The anode of the switching element DG1 is connected to the common antenna terminal CAT through a capacitor CG1. The anode is further connected, through the transmission line LG2, to a receive terminal RT for connecting the receiving circuit RX1 through a capacitor CG5. The cathode of the switching element DG2 is connected between the transmission line LG2 and the receive terminal RT1, and the anode is grounded through a capacitor CG6. Between the switching element DG2 and the capacitor CG6, the control terminal CT1 for connecting the control circuit VC 1 through series-connected resistor RG and inductor LG is connected in a shunt configuration. The cathode of the switching element DG1 is connected, through a low pass filter circuit LPF1, to a transmit terminal TT1 for connecting the transmitting circuit TX1 through a capacitor CG2. The low pass filter circuit LPF1 comprises an inductor LG3 and capacitors CG3, CG4, CG7. Between the low path filter circuit LPF1 and the transmit terminal TT1, the transmission line LG1 being grounded is connected in a shunt configuration.

The second switching circuit SW2 comprises switching elements DP1, DP2 and transmission lines LP1, LP2. The anode of the switching element DP1 is connected to the common antenna terminal CAT through a capacitor CP1 which may be omitted. The anode is further connected, through a transmission line LP2, to a receive terminal RT2 for connecting the receiving circuit RX2 through a capacitor CP5. The cathode of the switching element DP2 is connected between the transmission line LP2 and the receive terminal RT2, and the anode is grounded through a capacitor CP6. Between the anode and the capacitor CP6, a control terminal CT2 for connecting the control circuit VC2 through series-connected resistor RP and inductor LP is connected in a shunt configuration. The cathode of the switching element DP1 is connected, through a low pass filter circuit LPF2, to a transmit terminal TT2 for connecting the transmitting circuit TX2 through a capacitor CP2. The low pass filter circuit LPF2 comprises an inductor LP3 and capacitors CP3, CP4, CP7. Between the low path filter circuit LPF2 and the transmit terminal TT2, the transmission line LP 1 being grounded is connected in a shunt configuration. Series-connected inductor LP4 and capacitor 8 is connected to the switching element DP1 in parallel. This LC series circuit is optional, and improves the isolation characteristics when the switching element DP1 is in off-state.

The multiband high-frequency switching module of the above circuit is made into a form of laminate body comprising a plurality of dielectric layers, pattern electrodes formed on the dielectric layers, terminal electrodes made on the side surfaces of the laminate body, and circuit elements mounted to the top surface of the laminate body.

In the present invention, the common antenna terminal to which a plurality of transmit-receive systems are connected through the band-separating circuit, the transmit terminals for connecting the transmitting circuit of respective transmit-receive systems, and the receive terminals for connecting the receiving circuits of respective transmit-receive systems are made on the side surfaces of the laminate body, thereby enabling to mount the multiband high-frequency switching module to a circuit board through the bottom surface thereof. Each terminal may extend to the top or bottom surface.

On each of the four side surfaces, at least one ground terminal is preferably formed to reduce the insertion loss of the multiband high-frequency switching module. At least one ground terminal or control terminal for controlling the switching circuit, preferably the ground terminal, is disposed between the high-frequency terminals (the common antenna terminal, the transmit terminals and the receive terminals) on the side surface to prevent the high-frequency terminals from being positioned directly adjacent to each other. With such a configuration, the interference between the high-frequency terminals is minimized and the insertion loss is reduced. Also, the isolation between the signal terminals is made good.

In a more preferred embodiment, each of the high-frequency terminals is disposed between two ground terminals. With this configuration, the leakage of signals and the interference between the high-frequency terminals are more securely avoided and the isolation between the high-frequency terminals are enhanced.

The transmit terminals are preferred to be collectively positioned while being separated by the intervening ground terminal or control terminal as mentioned above. The receive terminals are also preferred to be collectively positioned. The transmit terminals and the receive terminals are preferably disposed on the opposite sides with respect to a vertical plane, perpendicular to the side surface having the common antenna terminal, dividing the laminate body into two equal parts. More preferably, the transmit terminals and the receive terminals are located symmetrically with respect to the vertical plane. Such a construction makes it easy to respectively connect the transmit terminals and the receive terminals to the respective transmitting circuits and the receiving circuits on the circuit board to which the multiband high-frequency switching module is to be mounted.

In addition, the common antenna terminal and the other high-frequency terminals (the transmit terminals and receive terminals) are preferably disposed on the opposite sides with respect to another vertical plane, preferably perpendicular to the above vertical plane and parallel to the side surface having the common antenna terminal, dividing the laminate body into tow equal parts. Since the multiband high-frequency switching module is disposed between the common antenna and the transmitting and receiving circuits, with such a configuration, the multiband high-frequency switching module can be connected to the common antenna and the transmitting and receiving circuits by the shortest lines, thereby to avoid an additional insertion loss.

As described above, it is preferable that the common antenna terminal is disposed on one of the two parts formed by dividing the laminate body with a first vertical plane parallel to the side surface having the common antenna terminal, and the transmit and receive terminals on the other. Assuming that the other half opposite to the common antenna terminal is further equally divided into two quadrisect parts by a second vertical plane perpendicular to the first plane, it is preferable that the transmit terminals is disposed on one of the quadrisect parts and the receive terminals on the other. In this configuration, the transmit terminals are collectively disposed on one quadrisect part and the receive terminals are collectively disposed on the other. Therefore, as described above, the connection of the multiband high-frequency switching module to the common antenna, the transmitting circuits and the receiving circuits is made by a short line to avoid an additional insertion loss.

In the laminate body, the circuit of the multiband high-frequency switching module is formed by the pattern electrodes formed on the dielectric layers and the chip elements mounted on the top surface of the laminate body.

The band-separating circuit and the transmission lines of the switching circuits are preferably formed by the pattern electrodes on the inner layers between the top layer and the bottom layer. More specifically, the transmission lines of the switching circuits are preferably formed by the pattern electrodes on the layers between the layers having the ground electrode patterns. The pattern electrodes for the band-separating circuit comprising a capacitor component and an inductor component are formed on the layers laminated on the layer having the upper ground electrode pattern. The pattern electrode for the inductor component is formed on the layer being laminated above the layer having the pattern electrode for the capacitor component.

In the present invention, it is preferable that the transmit system of at least one transmit-receive system has a low pass filtering function. This can be achieved by constituting the band-separating circuit from at least one low path filter circuit as described above. Another method is to incorporate a low path filter circuit into at least one switching circuit. For example, as shown in Fig. 2, the low path filter circuit LPF1 comprising the inductor LG3 and the capacitors CG3, CG4, CG7 is incorporated into the first switching circuit SW1, namely between the switching element DG1 and the transmission line LG1 each constituting the first switching circuit SW1. Such an incorporation of the low path filter circuit into the switching circuit makes the overall circuit symmetrical, thereby to reduce the insertion loss and secure high characteristics in broad band. The pattern electrodes for the low pass filter circuit to be incorporated into the switching circuit is preferably formed on the layers to be laminated above the layers having the pattern electrodes for the switching circuits. Specifically, the pattern electrodes for the capacitor component of the low pass filter circuit are formed on the layers above the layer having the upper ground pattern electrode, and the pattern electrode for the inductor component is formed on the layer being laminated above the layers having the capacitor pattern electrodes.

The pattern electrodes for the inductor components and the pattern electrodes for the capacitor components are preferably formed on the different layers. The capacitor pattern electrodes of the low pass filter circuit being incorporated into the switching circuit and the capacitor pattern electrodes of the band-separating circuit are preferred to be formed on the same layer separately. Also, the inductor pattern electrodes of the low pass filter circuit and the band-separating circuit are preferably formed on the same layer separately. The band-separating circuit and the low pass filter circuit may be connected to the switching circuit via through holes made on the layers intervening therebetween.

As described above, the laminate body of the present invention preferably comprises, from the bottom surface (mounting surface), the layer having the lower ground electrode, the layers having the transmission lines of the switching circuits, the layer having the upper ground electrode, the layers having the capacitor components of the band-separating circuit and the low pass filter circuit, and the layers having the inductor components of the band-separating circuit and the low pass filter circuit.

On the top surface of the laminate body, chip elements of the switching elements and the capacitors other than those constituting the band-separating circuit, the switching circuits and the low pass filter circuits are mounted. A metal cover for covering the chip elements may be disposed on the top surface of the laminate body while maintaining the terminal electrodes on the side surfaces exposed to the atmosphere. The metal cover may be fixed to the laminate body by soldering or a mounting device.

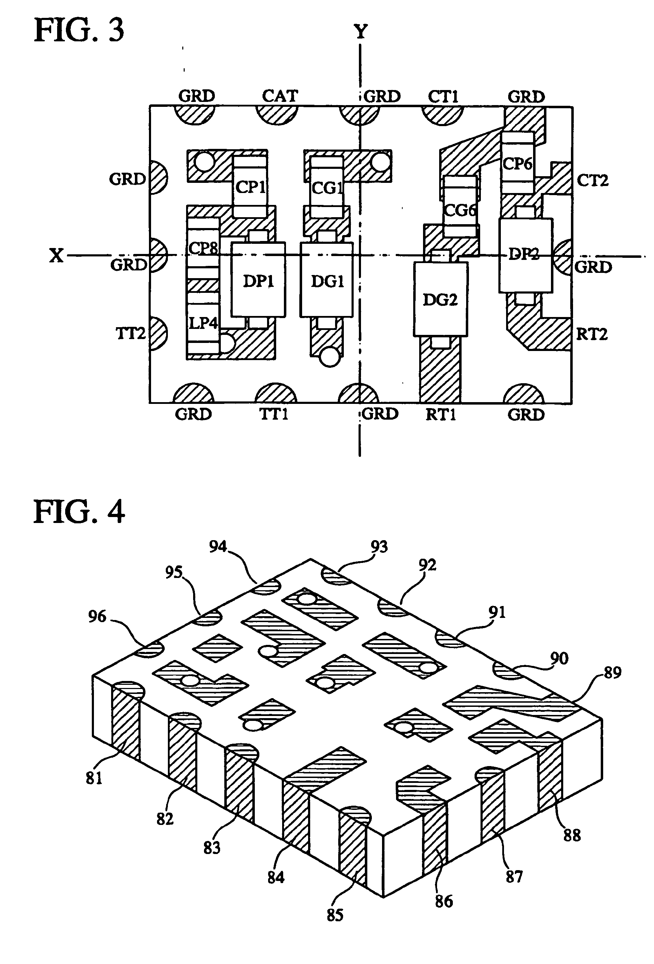

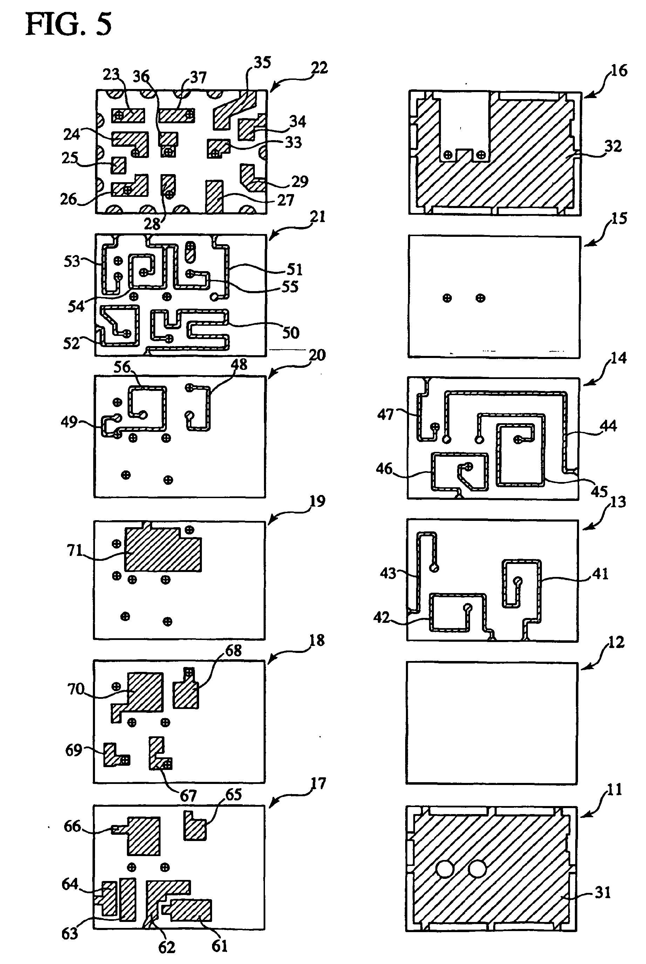

A plan view and a perspective view of a laminate body of the multiband high-frequency switching module having the equivalent circuit of Fig. 2 are shown in Fig. 3 and Fig. 4, respectively. Fig. 5 is a plan view showing each layer constructing the laminate body of Figs. 3 and 4. In this embodiment, the band-separating circuit, the low path filter circuits and the transmission lines of the switching circuits were formed on the inner layers of the laminate body. On the top surface of the laminate body, the switching elements and chip capacitors were mounted.

The laminate body was produced as described below. A green sheet made of a dielectric ceramic material sinterable at low temperatures was used as the layer. The pattern electrodes for each circuit element were formed by printing an electrically conductive paste mainly comprising Ag on the green sheets. The green sheets with pattern electrodes and, if desired, a green sheet with no pattern electrode (dummy layer) were stacked and sintered to produce the integral laminate body.

As best shown in Fig. 5, green sheets 11 to 22 were stacked in turn with the green sheet 11 disposed lowermost and with the green sheet 22 disposed uppermost. A ground electrode 31 was formed on nearly entire surface of the lowermost green sheet 11. The ground electrode 31 had ports for connecting the ground terminals (GRD) 81, 83, 85, 87, 89, 91, 93, 94 and 95 to be formed on the side surfaces of the resultant laminate body. On the lowermost green sheet 11, stacked was the dummy green sheet 12 with no pattern electrode.

On the green sheet 13, line electrodes 41, 42, 43 were printed. On the green sheet 14, line electrodes 44 to 47 were formed. Each of the line electrodes 45-47 had at one end thereof a through hole electrode shown by a circle with a cross. The green sheet 15 had only two through hole electrodes. The green sheet 16 having a ground electrode 32 was stacked on the green sheet 15. The line electrodes disposed between the ground electrodes 31 and 32 constitute the transmission lines of the first and second switching circuits, SW1, SW2. Specifically, the line electrodes 42 and 46 are connected to each other by the through hole electrode to constitute the transmission line LG1. Likewise, the line electrodes 41 and 45 constitute the transmission line LG2, and the line electrodes 43 and 47 constitute the transmission line LP1. The line electrode 44 constitutes the transmission line LP2.

On the green sheets 17 to 19, printed were the pattern electrodes 67 to 71 for constituting capacitors. The pattern electrodes 61 to 65 respectively constitute the capacitors CG4, CG3, CP4, CP3 and CF3, each with the ground electrode 32. Further, the electrodes 66 and 70, the electrodes 64 and 69, the electrodes 62 and 67, the electrodes 70 and 71 and the electrodes 68 and 71 respectively constitute the capacitors CF4, CP7, CG7, CF2 and CF1. The ground electrode 32 is partly cut out so that the electrode 66 opposes only to the electrode 70. In the cut out portion of the ground electrode 32, formed were two through hole electrodes communicated to the line electrodes 44 and 45.

On the green sheet 19, the green sheet 20 having line electrodes 48, 49, 56 was disposed. Line electrodes 50 to 55 were formed on the green sheet 21. On the uppermost green sheet 22, were formed lands 23 to 29 and 33 to 37 for connecting the chip elements, such as switching elements and chip capacitors, being mounted thereon. The line electrodes 48 and 55 were connected to each other via the through hole electrode to constitute LF1. Likewise, the line electrodes 54 and 56 constitute LF2, and the line electrodes 49 and 53 constitute LF3. The line electrodes 50 and 52 respectively constitute LG3 and LP3. The line electrode 51 is a DC line for the control circuit.

The above green sheets 11 to 22 were stacked, pressed and then sintered in a known manner to obtain an integral laminate body. On the side surfaces of the laminate body, the terminal electrodes 81 to 96 were formed as shown in Fig. 4. Then, switching elements DG1, DG2, DP1, DP2, chip capacitors CG1, CG6, CP1, CP6, CP8, and a chip inductor LP4 were mounted to the respective lands on the top surface of the laminate body to obtain a multiband high-frequency switching module of the present invention in the form of laminate body.

Of the circuit elements shown in Fig. 2, CP2, CP5, CG2, CG5, RG, LG, RP and LP are formed on the circuit board to which the multiband high-frequency switching module is mounted.

In the above embodiment, the transmission lines 41 to 47 of the first and second switching circuits are disposed between the ground electrodes 31, 32 to effectively prevent the interference between the switching circuits and the band-separating circuit and/or the low path filter circuits. Since the ground electrodes are disposed lower in the laminate body, the grounding is easily secured. The capacitors CG3, CG4, CP3, CP4, CF3 being grounded are formed by opposing the upper ground electrode 32 to the pattern electrodes 61 to 65 on the layer just above the upper ground electrode 32.

Also, since the terminal electrodes are formed on the side surface of the laminate body, the multiband high-frequency switching module can be mounted through its bottom surface. The high-frequency terminals (common antenna terminal CAT, transmit terminals TT1, TT2, receive terminals RT1, RT2) are located separately by the intervening ground terminal GRD and control terminal CT1, CT2. At least one ground terminal is disposed between the high-frequency terminals. In other words, any one of the high-frequency terminals is disposed between the ground electrodes. Further, at least one ground terminal is disposed on any of the side surfaces of the laminate body.

As shown in Fig. 3, the common antenna terminal CAT and the other high-frequency terminals (transmit terminals TT1, TT2 and receive terminals RT1, RT2) are located on opposite sides with respect to a vertical plane X parallel to the side surface having the common antenna terminal CAT and dividing the laminate body into two equal parts. Also, the transmit terminals TT1, TT2 and the receive terminals RT1, RT2 are located on opposite sides with respect to another vertical plane Y, perpendicular to the plane X, dividing the laminate body into equal two parts.

As described above, the multiband high-frequency switching module of the present invention alternately connects the common antenna to the transmitting or receiving circuit of a first transmit-receive system or the transmitting or receiving circuit of a second transmit-receive system. The first and second transmit-receive systems may be GSM system and DCS1800 system. However, the present invention is not limited to the above embodiment, and equally applicable to switching the transmitting circuits and the receiving circuits of a plurality of transmit-receive systems having different passbands.

The multiband high-frequency switching module of the present invention is suitable for use in a dual-band cellular radiotelephone, etc. Since the multiband high-frequency switching module can be made into a small chip with laminated structure, the present invention is effective for reducing the size of the dual-band cellular radiotelephone, etc.

## Claims

1. A multiband high-frequency switching module in the form of a laminate body for use in a communication system utilising a plurality of transmit-receive systems having different passbands, the circuit of said multiband high-frequency switching module comprising:
a band-separating circuit (2) having one end connected to a common antenna (ANT) and being constituted by filter circuits each comprising an LC circuit, and
a switching circuit (SW1, SW2) in each said transmit-receive system for switching a transmitting circuit (TX1, TX2) and a receiving circuit (RX1, RX2) in each said transmit-receive system, each switching circuit (SW1, SW2) having one end connected to said band-separating circuit (2) and the other end connected to both a receive terminal (RT1, RT2) for connection to said receiving circuit (RX1, RX2) and a transmit terminal (TT1, TT2) for connection to said transmitting circuit (TX1, TX2) so as to connect said common antenna (ANT) alternately to said receiving circuit (RX1, RX2) and said transmitting circuit (TX1, TX2), each switching circuit (SW1, SW2) comprising at least one transmission line (LG1, LG2; LP1, LP2),
wherein said laminate body comprises a plurality of horizontal dielectric layers (11-12), pattern electrodes (41-71) printed on said dielectric layers, terminal electrodes (81-96) formed on surfaces of said laminate body, and chip elements (CP1-LP4) mounted on a top surface of said laminate body, and
wherein said pattern electrodes (45, 44) of at least the transmission lines (LG2, LP2) connected to said receiving circuit (RX1, RX2) for said plurality of switching circuits (SW1, SW2) are formed on the same surface of at least one of said layers (13, 14).

2. The module of claim 1, wherein the layers containing said pattern electrodes (45, 44) of at least the transmission lines (LG2, LP2) connected to said receiving circuits (RX1, RX2) are disposed between layers (11, 16) having a lower and an upper ground electrode (31, 32).

3. The module of claim 1 or 2, wherein through hole electrodes are formed in a layer (16) forming one (32) from one of said upper and lower ground electrodes (32, 31), and the pattern electrodes (45, 44) of the transmission lines (LG2, LP2) connected to said receiving circuit (RX1, RX2) are connected to switch elements (DG1, DP1) mounted on said laminate body via said through hole electrodes.

4. The module of claim 3, wherein the pattern electrodes (45, 44) of the transmission lines (LG2, LP2) connected to said receiving circuit (RX1, RX2) are connected to said band separating circuit (2) formed on inner layers of said laminate body via said through hole electrodes.

5. The module of any preceding claim, wherein a grounded capacitor (CF3) is connected between the first filter circuit (NF1) of said band-separating circuit (2) and the first switching circuit (SW1) in a shunt configuration.

6. The module of claim 5, wherein a pattern electrode (65) to form a capacitor (CF3) in a shunt configuration is formed in said laminate body and is disposed in a position opposite from said one (32) of said upper and lower ground electrodes (32, 31).

7. The module of any preceding claim, wherein a capacitor (CF4) is connected between the second filter circuit (NF2) of said band-separating circuit (2) and the second switching circuit (SW2), and an inductor (LF3) connected to a line to be grounded is connected between said second filter circuit (NF2) and said capacitor (CF4).

8. The module of any preceding claim, wherein a transmit system comprising said common antenna (ANT), said band-separating circuit (2), said switching circuit (SW1, SW2) and the transmit terminal (TT1, TT2) of at least one transmit-receive system (GSM, DCS) has a low pass filtering function provided by a low pass filter circuit (LPF1, LPF2) comprising pattern electrodes (50, 52, 61, 62, 63, 64, 67, 69) formed in said laminate body.

9. The module of claim 8, wherein pattern electrodes (48, 55; 54, 56, 49, 53; 71, 68, 70, 65, 66) for said band-separating circuit (2) and pattern electrodes (50, 52, 61, 62, 63, 64, 67, 69) for said low pass filter circuit (LPF1, LPF2) are formed on layers (17, 18, 19, 20, 21) separately in the horizontal direction of said laminate body.

10. The module of claim 8 or 9, wherein said low pass filtering function is provided by a low pass filter circuit (LPF1, LPF2) incorporated in said switching circuit (SW1, SW2).

11. The module of any preceding claim, wherein pattern electrodes (48, 55, 54, 56; 49, 53; 50, 52) for inductors (LF1, LF2; LF3; LG3, LP3) and pattern electrodes (71, 68, 70, 66, 65, 62, 61, 67, 64, 63, 69) for capacitors (CF1, CF2, CF4; CF3; CG3; CG4; CG7; CP3; CP4, CP7) are printed on different layers (17, 18, 19, 20, 21).

12. The module of any preceding claim, wherein said common antenna (ANT), said receive terminals (RT1, RT2) and said transmit terminals (CT1, CT2) are formed on side surfaces of said laminate body, and wherein at least one ground terminal (GRD) is formed on each of said side surfaces.

13. The module of any preceding claim, wherein said switching circuit (SW1, SW2) of each transmit-receive system (GSM, DCS) is further connected to a control terminal (CT1, CT2) for connection to a control circuit (VC1, VC2), and wherein at least one of said ground terminals (GRD) and control terminals (CT1, CT2) is disposed between any adjacent high-frequency terminals, namely a terminal (CAT) of said common antenna (ANT), said transmit terminals (TT1, TT2) or said receive terminals (RT1, RT2).

14. The module of any preceding claim, wherein layers having pattern electrodes (42, 46; 41, 45; 43, 47; 44) for transmission lines (LG1, LG2, LP1, LP2) of said switching circuits (SW1, SW2), layers having pattern electrodes (61, 62, 63, 64, 65, 66; 67, 68, 69, 70; 71) for capacitors (CG4; CG3, CP4, CP3, CF3, CF4; CG7; CF1, CP7, CF4, CF2; CF1) and layers having pattern electrodes (48, 55; 54, 56; 49, 53; 50; 52) for inductors (LF1, LF2; LF3; LG3, LP3) are disposed in this order from a mounting surface of said laminate body.

15. The module of any preceding claim, wherein said switching circuit (SW1, SW2) of each transmit-receive system (GSM, DCS) is provided with switch elements (DG1, DG2; DP1, DP2) for switching said transmitting circuit (TX1, TX2) and said receiving circuit (RX1, RX2), each of said switch elements (DG2, DP2) having a control terminal (CT1, CT2) for controlling a transmit system of each transmit-receive system (GSM, DCS) and a common control terminal for controlling respective receive systems of said plurality of transmit-receive systems, the switching operation of said switch elements (DG1, DG2; DP1, DP2) being controlled by respectively applying a predetermined level of voltage to said control terminal (CT1, CT2) and said common control terminal.

16. The module of any preceding claim, wherein a metal case is disposed on said top surface of said laminate body so as to cover said chip elements.

17. A mobile phone utilizing the multi-band high-frequency switching module of any preceding claim.

## Patentansprüche

1. Mehrfachband-HF-Schaltmodul in Form eines Schichtkörpers zur Verwendung in einem mit mehreren Empfangs/Sende-Systemen unterschiedlicher Durchlassbänder arbeitenden Nachrichtensystem, wobei die Schaltung des Mehrfachband-HF-Schaltmoduls aufweist:
eine Bandtrennstufe (2), deren eines Ende mit einer gemeinsamen Antenne (ANT) verbunden ist und die aus jeweils einen LC-Kreis enthaltenden Filterstufen aufgebaut ist, und
einer Schaltstufe (SW1, SW2) in jedem der Empfangs/Sende-Systeme, zum Schalten eines Sendekreises (TX1, TX2) und eines Empfangskreises (RX1, RX2) in jedem der Empfangs/Sende-Systeme, wobei ein Ende jeder Schaltstufe (SW1, SW2) an die Bandtrennstufe (2) angeschlossen und das andere Ende mit sowohl einem Empfangsanschluss (RT1, RT2) zum Anschluss an den Empfangskreis (RX1, RX2) als auch einem Sendeanschluss (TT1, TT2) zum Anschluss an den Sendekreis (TX1, TX2) verbunden ist, um die gemeinsame Antenne (ANT) abwechselnd mit dem Empfangskreis (RX1, RX2) und dem Sendekreis (TX1, TX2) zu verbinden, und wobei jede Schaltstufe (SW1, SW2) mindestens eine Übertragungsleitung (LG1, LG2; LP1, LP2) enthält,
wobei der Schichtkörper mehrere horizontale dielektrische Schichten (11-12), auf diese aufgedruckte Musterelektroden (41-71), auf Flächen des Schichtkörpers ausgebildete Anschlusselektroden (81-96) und auf einer oberen Fläche des Schichtkörpers angebrachte Chipelemente (CP1-LP4) aufweist, und
wobei die Musterelektroden (45, 44) mindestens der mit dem Empfangskreis (RX1, RX2) verbundenen Übertragungsleitungen (LG2, LP2) für die mehreren Schaltstufen (SW1, SW2) auf derselben Fläche mindestens einer der Schichten (13, 14) ausgebildet sind.

2. Modul nach Anspruch 1, wobei die Musterelektroden (45, 44) mindestens der an die Empfangskreise (RX1, RX2) angeschlossenen Übertragungsleitungen (LG2, LP2) zwischen Schichten (11, 16) ausgebildet sind, die eine untere und eine obere Masseelektrode (31, 32) aufweisen.

3. Modul nach Anspruch 1 oder 2, wobei in einer Schicht (16), die eine (32) der oberen und unteren Masseelektrode (31, 32) bildet, Durchgangslochelektroden ausgebildet sind, über die die Musterelektroden (45, 44) der an den Empfangskreis (RX1, RX2) angeschlossenen Übertragungsleitungen (LG2, LP2) mit den auf dem Schichtkörper angebrachten Schaltelementen (DG1, DP1) verbunden sind.

4. Modul nach Anspruch 3, wobei die Musterelektroden (45, 44) der an den Empfangskreis (RX1, RX2) angeschlossenen Übertragungsleitungen (LG2, LP2) über die Durchgangslochelektroden mit der auf inneren Schichten des Schichtkörpers ausgebildeten Bandtrennstufe (2) verbunden sind.

5. Modul nach einem der vorhergehenden Ansprüche, wobei zwischen der ersten Filterstufe (NF1) der Bandtrennstufe (2) und der ersten Schaltstufe (SW1) ein an Masse liegender Kondensator (CF3) im Nebenschluss liegt.

6. Modul nach Anspruch 6, wobei in dem Schichtkörper eine einen Nebenschluss-Kondensator (CF3) bildende Musterelektrode (65) ausgebildet, die an einer der besagten einen (32) der oberen oder unteren Masseelektroden (32, 31) gegenüberliegenden Stelle angeordnet ist.

7. Modul nach einem der vorhergehenden Ansprüche, wobei zwischen der zweiten Filterstufe (NF2) der Bandtrennstufe (2) und der zweiten Schaltstufe (SW2) ein Kondensator (CF4) und zwischen der zweiten Filterstufe (NF2) und dem Kondensator (CF4) eine an eine Masseleitung anzuschließende Induktivität (LF3) liegt.

8. Modul nach einem der vorhergehenden Ansprüche, wobei ein die gemeinsame Antenne (ANT), die Bandtrennstufe (2), die Schaltstufe (SW1, SW2) und den Sendeanschluss (TT1, TT2) umfassendes Sendesystem mindestens eines Sende/Empfangs-Systems (GSM, DCS) eine Tiefpass-Filterfunktion aufweist, die von einer Tiefpass-Filterstufe (LPF1, LPF2) mit in dem Schichtkörper ausgebildeten Musterelektroden (50, 52, 61, 62, 63, 64, 67, 69) erzeugt wird.

9. Modul nach Anspruch 8, wobei Musterelektroden (48, 55, 54, 56; 49, 53; 71, 68, 70, 65, 66) für die Bandtrennstufe (2) und Musterelektroden (50, 52. 61. 62, 63, 64, 67, 69) für die Tiefpass-Filterstufe (LPF1, LPF2) in der Horizontalrichtung des Schichtkörpers getrennt auf Schichten (17, 18, 19, 20, 21) ausgebildet sind.

10. Modul nach Anspruch 8 oder 9, wobei die Tiefpass-Filterfunktion von einer in die Schaltstufe (SW1, SW2) eingebauten Tiefpass-Filterstufe (LPF1, LPF2) erzeugt wird.

11. Modul nach Anspruch 8, wobei Musterelektroden (48, 55, 54, 56; 49, 53; 50, 52) für Induktivitäten (LF1, LF2; LF3; LG3, LP3) und Musterelektroden (71, 68, 70, 66, 65, 62, 61, 67, 64, 63, 69) für Kondensatoren (CF1, CF2, CF4; CF3; CG3; CG4; CG7; CP3; CP4, CP7) auf verschiedene Schichten (17, 18, 19, 20, 21) aufgedruckt sind.

12. Modul nach einem der vorhergehenden Ansprüche, wobei ein Anschluss (CAT) der gemeinsamen Antenne (ANT), die Empfangsanschlüsse (RT1, RT2) und die Sendeanschlüsse (TT1, TT2) auf Seitenflächen des Schichtkörpers und mindestens ein Masseanschluss (GRD) auf jeder der Seitenflächen ausgebildet ist.

13. Modul nach einem der vorhergehenden Ansprüche, wobei die Schaltstufe (SW1, SW2) jedes Sende/Empfangs-Systems (GSM, DCS) außerdem mit einem Steueranschluss (CT1, CT2) zum Anschluss einer Steuerschaltung (VC1, VC2) verbunden ist und mindestens einer der Masseanschlüsse (GRD) und der Steueranschlüsse (CT1, CT2) zwischen benachbarten HF-Anschlüssen liegt, nämlich einem Anschluss (CAT) der gemeinsamen Antenne (ANT), den Sendeanschlüssen (TT1, TT2) und den Empfangsanschlüssen (RT1, RT2).

14. Modul nach einem der vorhergehenden Ansprüche, wobei Schichten mit Musterelektroden (42, 46; 41, 45; 43, 47; 44) für Übertragungsleitungen (LG1, LG2, LP1, LP2) der Schaltstufen (SW1, SW2), Schichten mit Musterelektroden (61, 62, 63, 64, 65, 66; 67, 68, 69, 70; 71) für Kondensatoren (CG4; CG3, CP4, CP3, CF3, CF4; CG7; CF1, CP7, CF4, CF2; CF1) und Schichten mit Musterelektroden (48, 55; 54, 56; 49, 53; 50; 52) für Induktivitäten (LF1, LF2; LF3; LG3, LP3) in dieser Reihenfolge von einer Aufbaufläche des Schichtkörpers ausgehend angeordnet sind.

15. Modul nach einem der vorhergehenden Ansprüche, wobei die Schaltstufe (SW1, SW2) jedes Sende/Empfangs-Systems (GSM, DCS) mit Schaltelementen (DG1, DG2; DP1, DP2) zum Schalten des Sendekreises (TX1, TX2) und des Empfangskreises (RX1, RX2) versehen ist, wobei jedes der Schaltelemente (DG2, DP2) einen Steueranschluss (CT1, CT2) zum Ansteuern eines Sendesystems jedes Sende/Empfangs-Systems (GSM, DCS) und einen gemeinsamen Steueranschluss zum Ansteuern jeweiliger Empfangssysteme der mehreren Empfangs/Sende-Systeme aufweist, und wobei der Schaltvorgang der Schaltelemente (DG1, DG2; DP1, DP2) durch Anlegen eines vorbestimmter Spannungspegels an den Steueranschluss (CT1, CT2) und den gemeinsamen Steueranschluss gesteuert wird.

16. Modul nach einem der vorhergehenden Ansprüche, wobei auf der oberen Fläche des Schichtkörpers ein die Chipelemente abdeckendes Metallgehäuse angeordnet ist.

17. Mobiltelefon mit dem Mehrfachband-HF-Modul nach einem der vorhergehenden Ansprüche.

## Revendications

1. Module de commutation multibande à haute fréquence sous la forme d'un corps laminé destiné à être utilisé dans un système de communication utilisant une pluralité de systèmes d'émission-réception ayant différentes bandes passantes, le circuit dudit module de commutation multibande à haute fréquence comprenant :
un circuit de séparation de bande (2) ayant une extrémité reliée à une antenne commune (ANT), et étant constitué par des circuits de filtre comprenant chacun un circuit LC ;
un circuit de commutation (SW1, SW2) pour chacun desdits systèmes d'émission-réception pour commuter un circuit de transmission (TX1, TX2) et un circuit de réception (RX1, RX2) dans chaque dit système d'émission-réception, chaque circuit de commutation (SW1, SW2) ayant une extrémité reliée audit circuit de séparation de bande (2) et l'autre extrémité reliée à la fois à une borne de réception (RT1, RT2), pour connecter un circuit de réception (RX1, RX2), et à une borne d'émission (TT1, TT2) pour connecter un circuit d'émission (TX1, TX2), de façon à connecter ladite antenne commune (ANT) tour à tour audit circuit de réception (RX1, RX2) et audit circuit de transmission (TX1, TX2), chaque circuit de commutation (SW1, SW2) comprenant au moins une ligne de transmission (LG1, LG2, LP1, LP2),
dans lequel ledit corps laminé comprend une pluralité de couches diélectriques (11-22), des électrodes à motif (41-71) imprimées sur lesdites couches diélectriques, des électrodes à motif (81-96) formées sur des surfaces dudit corps laminé et des éléments de puce (CP1-LP4) montés sur une surface supérieure dudit corps laminé, et
dans lequel lesdites électrodes à motif (45, 44) d'au moins les lignes de transmission (LG2, LP2) connectées audit circuit de réception (RX1, RX2) pour ladite pluralité de circuits de commutation (SW1, SW2), sont formées sur la même surface qu'au moins une desdites couches (13, 14).

2. Module selon la revendication 1, dans lequel les couches comprenant lesdites électrodes à motif (45, 44) d'au moins les lignes de transmission (LG2, LP2) connectées auxdits circuits de réception (RX1, RX2), sont agencées entre des couches (11, 16) ayant une électrode de masse inférieure et supérieure (31, 32).

3. Module selon la revendication 1 ou 2, dans lequel des électrodes à trou traversant sont formées dans une couche (16) formant l'une (32) desdites électrodes supérieure et inférieure (32, 31), et les électrodes à motif (45, 44) des lignes à transmission (LG2, LP2), connectées audit circuit de réception (RX1, RX2), sont connectées aux éléments de commutation (DG1, DP1) montés sur ledit corps laminé, grâce auxdites électrodes à trou traversant.

4. Module selon la revendication 3, dans lequel les électrodes à motif (45, 44) des lignes à transmission (LG2, LP2) connectées audit circuit de réception (RX1, RX2), sont connectées au circuit de séparation de bande (2) formé sur des couches intermédiaires du corps laminé grâce auxdites électrodes à trou traversant.

5. Module selon l'une des revendications précédentes, dans lequel une capacité (CF3) mise à la masse est connectée en dérivation entre le premier circuit de filtre (NF1) dudit circuit de séparation de bande (2) et le premier circuit (SW1).

6. Module selon la revendication 5, dans lequel une électrode à motif (65) destinée à former une capacité (CF3) en dérivation, est formée dans ledit corps laminé et agencée en un emplacement opposé à celui (32) de l'une desdites électrodes de masse supérieure et inférieure (32, 31).

7. Module selon l'une quelconque des revendications précédentes, dans lequel un condensateur (CF4) est connecté entre un second circuit de filtre (NF2) dudit circuit de séparation de bande (2) et le second circuit de commutation (SW2), et une bobine d'induction mise à la terre (LF3) est connectée entre ledit second circuit de filtre (NF2) et ledit condensateur (CF4).

8. Module selon l'une quelconque des revendications précédentes, dans lequel un système de transmission comprenant ladite antenne commune (ANT), ledit circuit de séparation de bande (2), ledit circuit de commutation (SW1, SW2) et ladite borne d'émission (TT1, TT2) d'au moins un système d'émission-réception a une fonction de filtrage passe-bas fournie par un circuit de filtre passe-bas (LPF1, LPF2) comprenant des électrodes à motif (50, 52, 61, 64, 67, 69) formées dans ledit corps laminé.

9. Module selon la revendication 8, dans lequel les électrodes à motif (48, 55 ; 54, 56, 49, 53 ; 71, 68, 70, 65, 66) pour ledit circuit de séparation de bande (2) et des électrodes à motif (50, 52, 61, 64, 67, 69) pour ledit circuit passe-bas (LPF1, LPF2) sont formées sur des couches (17-21) de manière séparée suivant la direction horizontale dudit corps laminé.

10. Module selon la revendication 8 ou 9, dans lequel ladite fonction de filtrage passe-bas est fournie par un circuit de filtre passe-bas (LPF1, LPF2) incorporé dans ledit circuit de commutation (SW1, SW2).

11. Module selon l'une quelconque des revendications précédentes, dans lequel des électrodes à motif (48-50, 52-56) pour les inductions (LF1, LF2 ; LF3 ; LG3, LP3) et des électrodes à motif (61-71) pour les condensateurs (CF1-CF4, CG3, CG4, CG7, CP3, CP4, CP7) sont imprimées sur différentes couches (17-21).

12. Module selon l'une quelconque des revendications précédentes, dans lequel une borne (CAT) de ladite antenne commune (CAT), lesdites bornes de réception (RT1, RT2) et lesdits bornes d'émission (TT1, TT2) sont formées sur des surfaces latérales dudit corps laminé, et dans lequel au moins une borne mise à la terre (GRD) est formée sur chacune desdites surfaces latérales.

13. Module selon l'une quelconque des revendications précédentes, dans lequel ledit circuit de commutation (SW1, SW2) de chaque système d'émission-réception (GSM, DCS) est en outre connecté à une borne de commande (CT1, CT2) pour connecter un circuit de commande (VC1, VC2), et dans lequel au moins une desdites bornes mises à la terre (GRD) et desdites bornes de commande (CT1, CT2) est agencée entre n'importe laquelle des bornes à haute fréquence adjacentes, à savoir une borne (CAT) de ladite antenne commune (ANT), lesdites bornes d'émission (TT1, TT2) et lesdites bornes de réception (RT1, RT2).

14. Module selon l'une quelconque des revendications précédentes, dans lequel des couches ayant les électrodes à motif (41-47) pour des lignes de transmission (LG1, LG2, LP1, LP2) desdits circuits de commutation (SW1, SW2), des couches ayant des électrodes à motif (61-71) pour des condensateurs (CF1-CF4, CG3, CG4, CG7, CP3, CP4, CP7), et des couches (20, 21) ayant des électrodes à motif (48-55) pour des inductions (LF1-LF3, LG3, LP3) sont agencées dans cet ordre, en partant d'une surface de montage dudit corps laminé.

15. Module selon l'une quelconque des revendications précédentes, dans lequel ledit circuit de commutation (SW1, SW2) de chaque système d'émission-réception (GSM, DCS) comprend des éléments commutateurs (DG1, DG2, DP1, DP2) pour commuter ledit circuit de transmission (TX1, TX2) et ledit circuit de réception (RX1, RX2), chacun desdits éléments commutateurs ayant une borne de commande (CT1, CT2) pour commander un système d'émission de chaque système d'émission-réception et une borne de commande commune pour commander les systèmes de réception respectifs desdits systèmes d'émission-réception, l'opération de commutation desdits éléments commutateurs (DG1, DG2, DP1, DP2) étant commandée en appliquant respectivement un niveau de tension prédéterminé à ladite borne de commande (CT1, CT2) et à ladite borne de commande commune.

16. Module selon l'une quelconque des revendications précédentes, dans lequel un boîtier métallique est disposé sur la surface supérieure dudit corps laminé de façon à recouvrir lesdits éléments de puce.

17. Téléphone mobile utilisant le module de commutation multibande à haute fréquence selon l'une quelconque des revendications précédentes.
